# EUROPEAN PATENT APPLICATION

(11) **EP 1 703 570 A1**
(43) Date of publication of application: **20.09.2006**
(21) Application number: 06005269.3
(22) Date of filing: 15.03.2006
(51) Int. Cl.: H01L 31/048, H01L 31/18

(54) **Method of manufacturing a solar cell module**

(30) Priority: 16.03.2005 JP 2005075531
(71) Applicant: FUJI ELECTRIC HOLDINGS CO., LTD., Kawasaki, 210-0856 (JP)
(72) Inventor: Wada, Takehito, 2-2-1 Nagasaka Yokosuka-shi Kanagawa 240 (JP)
(74) Representative: Hoffmann, Eckart

(57) **Abstract**

An object of the present invention is to provide a method of manufacturing a solar cell module composed of a plurality of solar cell submodules having a power generation layer on one surface of a lengthy flexible substrate (20) and connection electrodes (25) on the other surface. Adhesive resin (2) is preliminarily fixed on the power generation layers (22) of a solar cell 1 to protect the power generation layers (22), then, the solar cell 1 is divided into a plurality of solar cell submodules. Subsequently, the adjacent solar cells are interconnected by connecting the connection electrodes (25) with a connection wiring (4). After that, adhesive resin (5) is provided only on the surface opposite to the power generation layers (22) of the solar cell submodules and, together with the adhesive resin (2) on the surface of the power generation layers (22), is melted and adheres to a protective member or a support member.

## Description

The present invention relates to a method of manufacturing a solar cell module composed of a plurality of solar cell submodules, and in particular, to a method of manufacturing such solar cell module in which the solar cell submodules are formed by dividing a solar cell disposed on a lengthy flexible substrate.

Solar cells are recently drawing attention as a sustainable energy source. For the solar cells to be more widely applied, it is essential to reduce the price and thus the manufacturing costs. So, a roll-to-roll production method for thin film solar cells, in which solar cells are produced on a flexible substrate while the latter is being transported, is expected to allow low costs and become useful.

In manufacturing a solar cell module composed of a plurality of solar cell submodules that are formed by dividing a solar cell and connected with one another, it has been proposed to enhance the performance and aim at protection of the solar cell (see for example JP 2000-349308 A). In the method of the document, a sheet of adhesive resin is preliminarily fixed on a power generation layer of the solar cell to prevent degradation of performance due to damage, break, or contamination. Then, the solar cell submodules are connected by connecting lead-out electrodes on the surface opposite to the power generation layer with connection members. Adhesive resin, a protective member and a support member are provided on both surfaces, followed by heating and adhesion.

In this conventional method of manufacturing a solar cell module, after connecting the lead-out electrodes of the solar cell submodules with connection members, adhesive resin is provided again on the whole surface of the power generation layer side of the solar cell submodules in order to make the surface protective member adhere to the portion of the connection member without contact to the solar cell submodule, increasing the number of sheets required in manufacturing process, adding cost of molding of the resin, and requiring additional work for the production.

An object of the present invention is to provide a method of manufacturing a solar cell module that reduces the necessary amount of materials and works for production and decreases the manufacturing costs, while preventing poor adhesion between connection members and a surface material which functions as protection material.

This object is achieved by a method as claimed in claim 1.

To solve the above problem, the present invention provides a method of manufacturing a solar cell module composed of a plurality of solar cell submodules that are formed by dividing a solar cell having power generation layers on one surface of a lengthy flexible substrate and lead-out electrodes on the other surface. The manufacturing method comprises a step of preliminarily fixing adhesive resin on photoelectric conversion elements of a solar cell, a step of dividing the solar cell into the plurality of solar cell submodules, a step of making connection between the lead-out electrodes of the solar cell submodules, and a step of providing adhesive resin on a surface opposite to the photoelectric conversion elements of the solar cell submodules and allowing this adhesive resin and the adhesive resin on the photoelectric conversion elements to melt and adhere to a back surface material which functions as a reinforcing material.

This method of manufacturing a solar cell module, in which the adhesive resin is provided on the surface opposite to the photoelectric conversion elements after connecting adjacent solar cell submodules, reduces materials and works required by production and decreases manufacturing costs, while preventing poor adhesion of connection members and a back surface material.

A method of manufacturing a solar cell module according to the invention, in which the adhesive resin is provided on the surface opposite to the photoelectric conversion elements after connecting the lead-out electrodes of the solar cell submodules, has the merits to reduce materials and works required by production and decrease the manufacturing costs, while preventing poor adhesion of connection members and a back surface material.

The following describes some preferred embodiments according to the invention with reference to accompanying drawings.

### BRIEF DESCRIPTION OF THE DRAWINGS

- Fig. 1: shows a lamination structure of a solar cell module of an embodiment according to the invention;
- Fig. 2: is a plan view of the overall structure of a solar cell module of an embodiment according to the invention;
- Fig. 3: shows a cross-sectional structure in a solar cell submodule in an embodiment according to the invention; and
- Fig. 4: shows a manufacturing procedure of a solar cell module in an embodiment according to the invention.

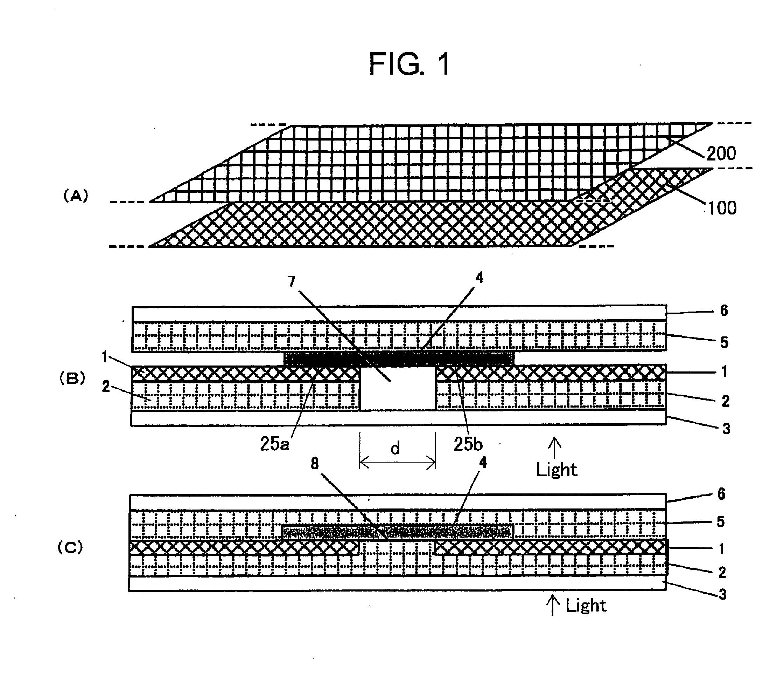

Fig. 1 shows a lamination structure of a solar cell module of an embodiment according to the invention. A solar cell 100 comprises a lengthy (or web-like, i.e., having a length greater or even substantially greater than the width) flexible substrate and photoelectric conversion elements formed on the substrate. As shown in Fig. 1(A), an adhesive resin sheet 200 such as EVA is attached onto the surface side of the photoelectric conversion elements of the solar cell 100 to protect the power generation layers of the solar cell 100. Each power generation layer corresponds to one of the solar cell submodules to be formed.

Subsequently, the solar cell 100 with the adhesive resin sheet 200 placed thereon is divided to form a plurality of solar cell submodules 1. After that process, as shown in Fig. 1(B), a surface material 3 composed of an ETFE film which functions as protection material, a fluorine-containing film exhibiting high durability against light, is disposed on the plane of incident light of the solar cell submodules 1 having the adhesive resin 2. Then, connection members 4 composed of a conductive tape with an adhesive substance are stuck on a region of lead-out electrodes on the surface opposite to the plane of incident light, to interconnect the connection electrodes of the solar cell submodules. On this article, adhesive resin 5 in the form of an EVA sheet, which is an adhesive film, is provided. Finally, a back surface material 6 of ETFE is disposed.

Adhesion of the thus laminated materials is carried out by melting the adhesive resins 2 and 5 in a heating and vacuum lamination process. While a space 7 free of resin exists between the connection member 4 and the front surface material 3 before melting, after the adhesive resins 2 and 5 are melted and compressed in the lamination process, the space 7 is filled with the adhesive resins 2 and 5 and all members become a monolithic body as shown in Fig. 1(C). The numeral 8 indicates the filled-up space.

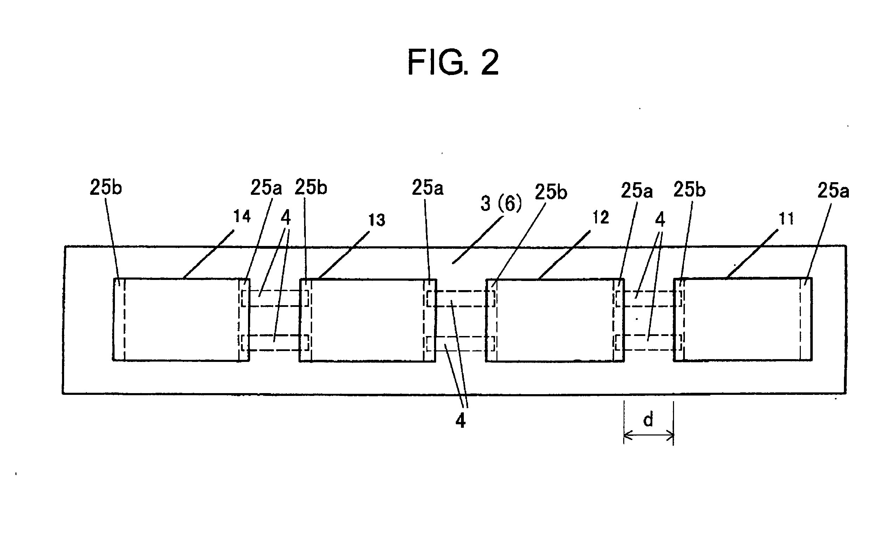

Fig. 2 is a plan view of the overall structure of the solar cell module of this embodiment. The solar cell module is composed of a plurality (four, in this example) of solar cell submodules 11, 12, 13, and 14 formed on a front surface material 3. Lead-out electrodes 25a and 25b (not shown) of these solar cell submodules are interconnected in series through the connection members 4. The solar cell submodules are viewable in this figure because the front surface material 3 is transparent.

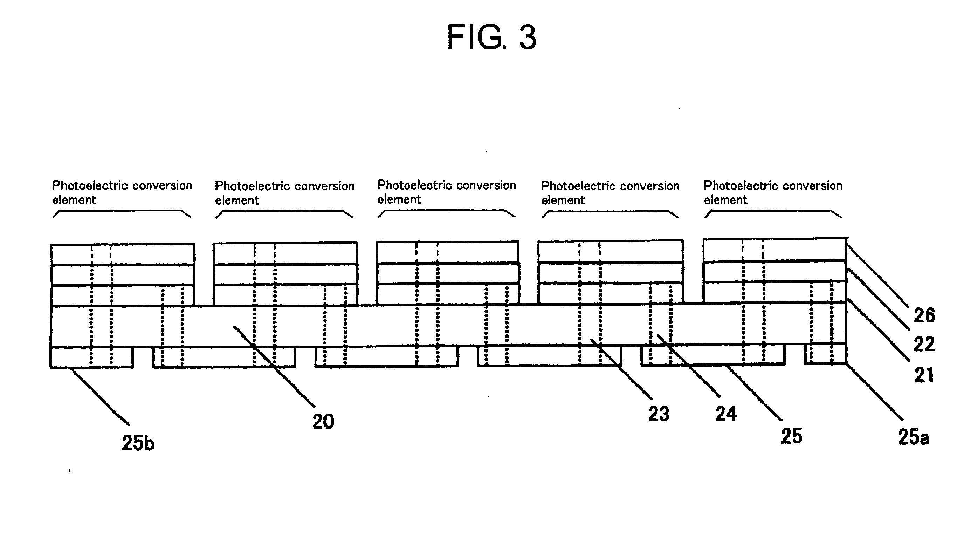

Fig. 3 shows a cross-sectional structure of the solar cell submodules 11, 12, 13, and 14 in Fig. 2 in this embodiment. This structure is common in the solar cell submodules 11, 12, 13, and 14.

As shown in Fig. 3, a bottom electrode 21, a transparent electrode 26, and a power generation layer 22 are provided on one surface of a continuous flexible substrate 20. A plurality of the photoelectric conversion element is connected in series by through-holes 23 and 24 and a back electrode 25 provided on the surface of the flexible substrate opposite to the power generation layer 22. The electrodes at both ends constitute lead-out electrodes 25a and 25b.

The solar cell submodule of this lamination structure can have a tandem structure consisting of amorphous silicon (a-Si) and amorphous silicon germanium (a-SiGe), and the flexible substrate 20 can be made from polyimide. The flexible substrate 20 can also be a film of a resin selected from PET, PEN, polyamide, polyamideimide, polycarbonate, PBT, PPS, liquid crystalline polymer, and PEI, or a stainless steel substrate. The power generation layer 22, which is a semiconductor layer, can also be composed of amorphous silicon carbide (a-SiC), microcrystalline silicon (µc-Si), µc-SiGe, µc-SiC, or µc-Ge. In addition, the solar cell can be composed of a photoelectric conversion element of single structure or three layer tandem structure, or further, a compound solar cell, a dye-sensitized solar cell, or an organic solar cell.

The adhesive resins 2 and 5 shown in Fig. 1 make the protective members (the front surface material 3 and the back surface material 6) adhere to the solar cell submodules). The adhesive resin must be stable against heat and moisture. Consequently, transparency as well as stability to light is needed for the adhesive resins 2 and 5 when the adhesive resins are disposed on the plane of incident light of the photoelectric conversion elements. The adhesive resin further needs to be worked in a short time, and to trace the shapes of the protective member and the solar cell. In some cases, the adhesive resin is expected to absorb external force and avoid damage. Therefore, a thermoplastic resin is employed for the adhesive resin.

Specifically, ethylene vinyl acetate copolymer (EVA) was used in an example. The material of the adhesive resin can also be selected from polyvinyl butyral, silicone resin, ethylene-acrylate copolymer resin, ethylene methacrylic acid copolymer, acrylic resin, polyethylene, polypropylene and the like. The adhesive resin is used in the form of a sheet because it is used in a roll-to-roll process. The sheet actually used in the example had a thickness of 0.4 mm and a length of 300 m. Adhesion was carried out by melting the EVA using a roll heater at 120°C and pressing the EVA to the photoelectric conversion element side of the solar cell submodules aligned.

The thickness of the EVA sheet need not be 0.4 mm but may be any value in the range of 0.1 mm to 2 mm. The adhesive resin need not necessarily be a sheet, but extrusion can be employed to carry out sheet molding and adhesion simultaneously.

While an EVA sheet has been mentioned as the adhesive film 5 of the back surface side, this adhesive film can be made from other resins. Moreover, the adhesive film need not be composed of only a single resin but may be a multilayer type and may be or include a fluororesin film and/or a woven or non-woven fabric of glass may be inserted in the adhesive films.

While an ETFE film has been mentioned a the surface material 3 of the light incident side, in this embodiment, it can be a film of PTFE, FEP, PFA, PVDF, or PVF, or further, a silicone resin film. Glass or a transparent resin can also be used. The surface material 6 of the side remote from the light incident side is also a ETFE film in the embodiment described so far, but can as well be one of the materials described above for the surface material on the light incident surface, and further, can be selected from a tile, an aluminum plate, concrete, a pre-coated steel sheet, and a glass plate.

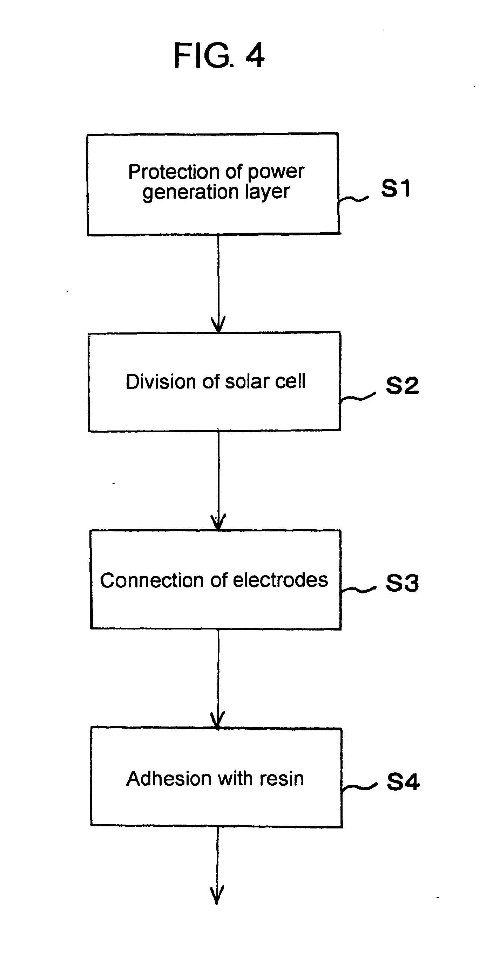

Fig. 4 shows an embodiment of a manufacturing procedure of a solar cell module according to the invention. This embodiment is a method of manufacturing a solar cell module composed of a plurality of solar cell submodules that are formed by dividing a solar cell having power generation layers on one surface of a continuous flexible substrate and connection members on the other surface. The method comprises the following steps.
(1) preliminarily fixing adhesive resin on the photoelectric conversion elements of the solar cell (S1);
(2) dividing the solar cell into the plurality of solar cell submodules (S2);
(3) making interconnection between the lead-out electrodes of the solar cell submodules (S3); and
(4) providing adhesive resin on a surface opposite to the photoelectric conversion elements of the solar cell submodules, and melting and allowing this adhesive resin and the adhesive resin on the power generation layers to adhere to a protective member or a support member (S4).

In this method, after the adhesive resin is preliminarily fixed on the photoelectric elements of the solar cell having the power generation layers formed on one surface of a lengthy flexible substrate, the solar cell is divided into solar cell submodules. Then, adjacent solar cell submodules are interconnected by interconnecting the lead-out electrodes of the solar cells with connection members. After that, adhesive resin is provided on the surface opposite to the power generation layers of the solar cell submodules, and this adhesive resin together with the adhesive resin on the side of power generation layers is melted and adhered to the protective member or the support member.

Because the adhesive resin is provided only on the surface side opposite to the power generation layers after connecting adjacent solar cell submodules, the materials and works required by manufacture can be decreased and the manufacturing costs can be reduced, while preventing poor adhesion of the connection members and the surface material.

The following describes some specific examples of the method of manufacturing a solar cell module.

### Example 1

The substrate for the solar cells used in this example was an opaque polyimide substrate, 50 µm thick. EVA, 0.4 mm thick, and ETFE, 25 µm thick, were used on the light incident side. The conductive tape for the connection members was 8 mm wide. On the surface side opposite to the light incident side, EVA, 0.4 mm thick, and ETFE 0.8 mm thick, were used.

A vacuum lamination process was carried out with the following sequence:
Process (1) - evacuation: temperature 80°C, pressure 0 atm (0 Pa), duration 5 min;
Process (2) - pressing: temperature 120°C, pressure 1 atm (1 x 10⁵ Pa), duration 10 min;
Process (3) - curing: temperature 150°C, pressure 1 atm (1 x 10⁵ Pa), duration 20 min.

Table 1 shows the distance d between the divided solar cell submodules and existence of a clearance (void spaces, i.e., parts which may cause defects) lacking adhesive resin on the conductive tapes which are the connection members. It is understood that the resin adheres well to the conductive tapes within a range of the distance d equal to or less than 2.5 mm.

**Table 1**

| distance (mm) | 1 | 2 | 2.5 | 3 | 3.5 | 4 |
|---|---|---|---|---|---|---|
| clearance | none | none | none | existing | existing | existing |

### Example 2

A solar cell module was manufactured in a similar manner as in Example 1 except that the thickness of the EVA on the light incident side was 0.8 mm.

Table 2 shows the distance d between the divided solar cell submodules and existence of a clearance (void spaces, i.e., parts which may cause defects) lacking adhesive resin on the conductive tapes which are the connection members. It is understood that the resins well adhere to the conductive tapes within a range of the distance d equal to or less that 4 mm.

**Table 2**

| distance (mm) | 2 | 3 | 4 | 5 |
|---|---|---|---|---|
| clearance | none | none | none | existing |

As shown in the tables for the examples, the distance between the adjacent solar cell submodules is preferably about five times or less of the thickness of the adhesive resin on the side of the power generation layers.

## Claims

1. A method of manufacturing a solar cell module composed of a plurality of solar cell submodules that are formed by dividing a solar cell (1) having power generation layers (22) on one surface of a flexible substrate (20) and lead-out electrodes (25) on the other surface, the method comprising steps of:
preliminarily fixing adhesive resin (2) on the power generation layers (22) of the solar cell (1),
dividing the solar cell (1) into the plurality of solar cell submodules,
making connection between the lead-out electrodes (25) of the solar cell submodules, and
providing adhesive resin (5) on a surface opposite to the power generation layers (22) of the plurality of solar cell submodules, and allowing this adhesive resin (5) and the adhesive resin (2) on the power generation layers (22) to melt and adhere to a protective member or a support member.

2. The method according to claim 1, wherein a distance between adjacent solar cell submodules is about five times or less of the thickness of the adhesive resin (2) on the power generation layers (22).
